**Europäisches Patentamt**

(19) **European Patent Office**

**Office européen des brevets**

(11) Numéro de publication: **0 045 689**
**B1**

(12) **FASCICULE DE BREVET EUROPEEN**

(45) Date de publication du fascicule du brevet: 06.06.84

(51) Int. Cl.³: **C 30 B 13/22,** C 30 B 29/06

(21) Numéro de dépôt: **81401228.2**

(22) Date de dépôt: **29.07.81**

(54) Procédé d'élimination du bore dans le silicium par fusion de zone sous plasma réactif.

(30) Priorité: **01.08.80 FR 8017120**

(43) Date de publication de la demande:
**10.02.82 Bulletin 82/6**

(45) Mention de la délivrance du brevet:
**06.06.84 Bulletin 84/23**

(84) Etats contractants désignés:
**BE DE NL**

(56) Documents cités:
**DE - A - 1 619 951
DE - A - 2 608 965
FR - A - 1 469 486
FR - A - 2 438 499**

(73) Titulaire: **ELECTRICITE DE FRANCE Service National, 2, rue Louis Murat, F-75008 Paris (FR)**

(72) Inventeur: **Amouroux, Jacques, 11, rue Pierre et Marie Curie, F-75231 Paris Cedex 05 (FR)**
Inventeur: **Morvan, Daniel, 11, rue Pierre et Marie Curie, F-75231 Paris Cedex 05 (FR)**

(74) Mandataire: **Fort, Jacques et al, CABINET PLASSERAUD 84, rue d'Amsterdam, F-75009 Paris (FR)**

BUNDESDRUCKEREI BERLIN

## Description

L'invention a pour objet un procédé de purification du silicium par fusion de zone, permettant notamment l'élimination du bore. Elle trouve une application particulièrement importante, bien que non exclusive, constituée par la fabrication de silicium utilisable pour la constitution de cellules photovoltaïques à partir de silicium industriel.

Pour que le silicium soit utilisable pour constituer des cellules photovoltaïques, sa teneur en divers éléments doit être inférieure à des seuils très bas. En particulier, la teneur en éléments qualitfiés de »tueurs« d'électrons (V, Cr, Ti, Zr, Na, Cu par exemple) doit être inférieure à 50 ppb. La teneur en éléments neutres (notamment Fe, Ni, Mg, C, Mn) ne doit pas dépasser 1 ppm environ. Enfin, la teneur en éléments dopants constitués par des impurestés, parmi lesquels le bore et l'aluminium sont majoritaires de sorte que le silicium obtenu est de type p, doit être réduite à une valeur extrêmement faible, afin de pouvoir doser de façon très précise la teneur finale en éléments dopants.

On connaît déjà un procédé de purification de silicium par fusion de zone suivant lequel on effectue la fusion d'une zone d'un lingot du silicium à purifier, en dirigeant sur cette zone un jet de plasma chaud obtenu par excitation haute fréquence, et on déplace, l'un par rapport à l'autre, le jet de plasma et le lingot pour faire circuler la zone fondue le long du lingot une ou plusieurs fois. Les procédés connus de ce type utilisent un plasma constitué à partir d'un gaz plasmogène, notamment l'argon, et souvent l'hydrogène, à une teneur plus faible que le gaz plasmogène (FR-A-2 438 499). L'hydrogène a une réactivité qui favorise en effet l'élimination de certaines impuretés. Mais l'élimination du bore reste difficile par ce procédé, comme par les autres procédés de fusion de zone antérieurement connus. En effet, le bore donne avec le silicium des composés définis très stables tels que $Si_xB_y$. De plus, le bore a un coefficient de partage théorique dans le silicium entre la phase liquide et la phase solide proche de l'unité.

La présente invention vise à fournir un procédé de purification de silicium répondant mieux que ceux antérieurement connus aux exigences de la pratique, notamment en ce qu'ils permettent d'éliminer le bore.

Dans ce but, l'invention propose un procédé caractérisé notamment en ce que l'on constitue le plasma d'un mélange de gaz plasmogène, tel que l'argon ou l'hélium, et d'oxygène à teneur suffisamment faible pour ne pas oxyder le silicium de façon appréciable.

Le procédé ci-dessus défini va directement à contre-courant des idées communément admises, suivant lesquelles il était néccessaire d'éviter la présence d'oxygène dans le plasma, car on pensait que, même à faible teneur, il conduisait à une oxydation gênante du silicium.

Selon l'invention, on ajuste la teneur en oxygène du plasma à une valeur comprise entre 100 et 300 fois la teneur en bore, ce qui conduit, pour les teneurs en bore du silicium industriel courant, à une teneur en oxygène du plasma qui reste suffisamment faible pour éviter l'oxydation du silicium. Dans la pratique, la teneur en oxygène sera en effet comprise entre 0,005 et 0,1%, selon la teneur initiale en bore du silicium. Plusieurs passages sous le jet de plasma éventuellement avec des teneurs différentes en oxygène, peuvent être nécessaires pour arriver à une teneur suffisamment faible.

Les résultats favorables obtenus par l'invention peuvent probablement être attribués à la transformation du bore en borosilicate, qui est amené à la surface de la barre et en queue du barreau. Ce borate, produit par la décomposition de $Si_xB_y$, se transforme en composés volatils de type $B_2O_3$ qui s'échappent à la surface du lingot de silicium et en queue de celui-ci. Une élimination complémentaire peut être effectuée par attaque à l'acide, après fusion de zone ou après chaque passage. On peut notamment utiliser une attaque par un mélange d'hydracide, en particulier d'acide fluorhydrique, et d'acide nitrique, suivant une technique en soi connue.

L'adjonction d'oxygène au plasma n'exclut pas l'adjonction simultanée d'une teneur en hydrogène qui sera typiquement de l'ordre de 1% pour profiter de la réactivité propre à l'hydrogène et de l'élévation de température, qui permet l'élimination d'autres impuretés. Par contre, il sera généralement souhaitable d'éviter la présence d'azote qui provoquerait une nitruration du silicium.

Le procédé suivant l'invention peut être mis en oeuvre dans un dispositif qui comporte, de façon classique, une nacelle contenant le lingot à traiter et un moyen de déplacement relatif de la nacelle par rapport à la torche de plasma. Mais cette torche à plasma sera associée à des moyens permettant de l'alimenter en un mélange de gaz plasmogène et d'oxygène à une teneur ajustable, par exemple à l'aide d'une vanne à fuite contrôlée. La nacelle doit être munie de moyens de refroidissement, de façon que la fusion s'effectue en »auto-creuset«, afin qu'aucune impureté de la nacelle ne s'introduise dans le lingot en cours de traitement.

Le plasma lui-même est avantageusement généré par une méthode purement inductive, donc sans aucune électrode qui pourrait également introduire des impuretés dans le plasma.

L'invention sera mieux comprise à la lecture de la description qui suit d'un procédé de purification qui constitue un mode particulier de réalisation de l'invention, ainsi que d'un dispositif permettant de le mettre en oeuvre, donnés à titre d'exemples non limitatifs. La description se réfère au dessin qui l'accompagne, dans lequel:

la fig. 1 est une courbe montrant la variation du taux de bore évaporé hors d'un barreau de silicium, en fonction du pourcentage d'oxygène introduit dans le plasma de traitement, pour un barreau de silicium électronique dopé à 74 ppm de bore;

la fig. 2 est un schéma de principe d'un dispositif particulier de mise en oeuvre de l'invention;

la fig. 3 est une courbe représentative de la répartition du bore dans un barreau de silicium, après traitement par un plasma sans adjonction d'oxygène (courbe en trait plein) et contenant une teneur déterminée d'oxygène (courbe en tirets).

Avant de décrire un dispositif permettant de mettre en oeuvre l'invention, on fera apparaître les résultats que permet d'atteindre celle-ci, et l'influence de la teneur en oxygène du plasma.

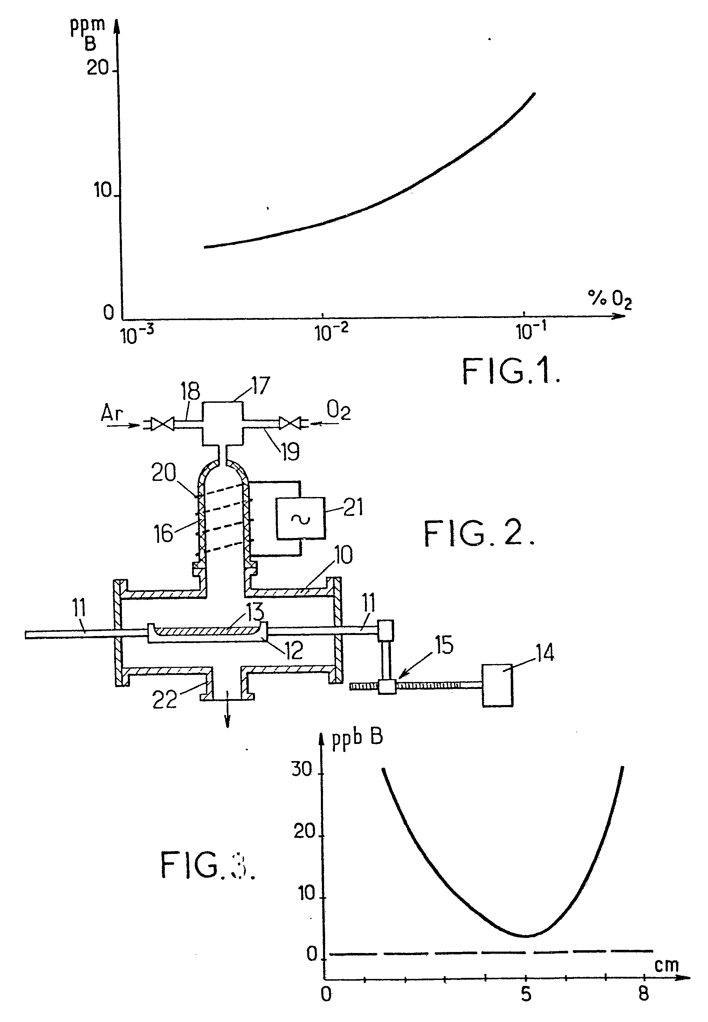

Des essais effectués ont montré que le bore éliminé, notamment par vaporisation d'un composé volatil, dépend en particulier de la teneur en oxygène du plasma. La courbe de la fig. 1 montre, à titre d'exemple, la variation du poids de bore éliminé par évaporation en fonction du pourcentage d'oxygène dans le plasma, dans le cas d'un échantillon constitué par un barreau de silicium de qualité électronique dopé à 74 ppm de bore (soit $10^{17}$ at/cm$^3$). Les essais, effectués avec un plasma constitué d'argon à 0,1% d'hydrogène, avec une quantité varible d'oxygène, montrent que la teneur de bore éliminé en quatre passages augmente avec la teneur en oxygène du plasma. On peut déduire, d'essais similaires à ceux dont les résultats sont donnés en fig. 1, la composition optimale d'oxygène à utiliser pour traiter un silicium particulier. Comme on l'a indiqué plus haut, il sera généralement avantageux d'utiliser une quantité d'oxygène 100 fois à 300 fois plus importante que la quantité de bore à éliminer. Toutefois, cette régle pourrait conduire à utiliser une teneur en oxygène excessive et, dans la pratique, on se limitera à 0,1% environ d'oxygène. Le procédé peut être mis en oeuvre dans le dispositif montré en fig. 2. Ce dispositif comporte une enceinte 10 de forme cylindrique à axe horizontal, fermée par des fonds étanches percés d'ouvertures de passage de tiges 11 supportant une nacelle 12 destinée à recevoir le lingot ou barreau 13 de silicium à purifier. Un mécanisme, schématisé par un moteur 14 et une liaison vis-écrou 15, permet de déplacer la nacelle parallèlement à l'axe de l'enceinte 10. Cette dernière porte, à sa partie supérieure, un raccord sur lequel est monté de façon étanche un tube 16 en matériau isolant, par exemple en quartz, destiné à la formtion du plasma. Ce tube reçoit, à sa partie supérieure, un mélange du gaz plasmogène et des additifs, dont l'oxygène. Sur la fig. 2, le dispositif d'amenée comporte une chambre de mélange 17 dans laquelle débouchent une conduite 18 d'amenée de gaz plsmogène (argon ou hélium purifié, en général) munie d'une vanne de réglage, et une conduite 19 d'amenée d'oxygène, munie d'une vanne de fuite contrôlée permettant de régler le débit d'oxygène à un niveau très faible et précis.

Le champ haute fréquence de création du plasma est produit par un enroulement 20 bobiné autour du tube 16 et alimenté par un générateur à haute fréquence 21, de puissance suffisante.

L'enceinte 10 peut encore comporter un raccord 22 permettant de relier l'enceinte à une pompe à une pompe à vide, afin de purger l'enceinte ou d'améliorer la circulation de gaz à une pression voisine de la pression atmosphérique.

La mise en oeuvre du procédé dans le dispositif montré en fig. 2 s'effectue suivant un processus très similaire à celui de la fusion de zone, si ce n'est que le plasma dirigé vers le silicium contenu dans la nacelle 12 a une composition différente. De plus, il est indispensable de maintenir la nacelle, par exemple par circulation de fluide réfrigérant, à une température telle que la partie inférieure du lingot reste non fondue. De cette façon, le gradient thermique responsable du processus de purification atteint son efficacité maximale avec un plasma qui chauffe la surface du barreau à une température légèrement inférieure à sa température d'ébullition.

Dans tous les cas, le bore donne naissance à des composés volatils de type $B_2O_3$ qui s'évaporent par la surface du lingot. Il y a, de plus, concentration en queue du barreau, par le processus classique de fusion de zone. Ce bore, drainé en queue, peut être éliminé par attaque acide.

On peut encore ajouter au plasma une teneur d'hydrogène choisie pour éliminer des impuretés autres que le bore par surchauffe de la surface du lingot.

On décrira maintenant, à titre d'exemples, les résultats obtenus avec deux échantillons de silicium dopé au bore, de pureté électronique, de façon à permettre le contrôle de la pureté par mesure de résistivité, sans influence d'autres impuretés.

Deux types d'échantillons ont été essayés.

Le premier échantillon était constitué par du silicium dopé à 34 ppb de bore, soit $45 \cdot 10^{15}$ at/cm$^3$. La résistivité de départ était de 3 Ωcm. Un seul passage sous plasma d'argon à 0,01% d'oxygène permet d'éliminer le bore presque totalement: la résistivité passe de 3 Ωcm à 150 Ωcm tout au long du parcours. On peut effectuer un second traitement, cette fois avec un plasma argon-hydrogène, pour éliminer les défauts introduits par le premier traitement et obtenir un monocristal. La résistivité passe alors de 150 à 300 Ωcm.

Les résultats obtenus sont indiqués par la courbe en tirets de la fig. 3, qui montre la teneur finale en bore de l'échantillon le long du barreau, pour une vitesse de traitement de 40 cm/h, avec un débit d'argon de 35 l/mn et un débit d'oxygène de 2,5 cm$^3$/mn. Au cours de la seconde phase, le débit d'hydrogène était de 70 cm$^3$/mn. Une comparaison avec la courbe en trait plein, correspondant à un traitement dans les mêmes conditions, mais sans oxygène, montre qu'au lieu d'une teneur de 0,6 ppb environ tout le long du barreau, on conserve, en queue du barreau, une teneur élevée après deux passages. La teneur moyenne le long du barreau est de 20 ppb environ. L'élimination du bore s'effectue malgré tout, mais très lentement, du fait de la légère teneur d'oxygène contenue dans l'argon utilisé, de l'ordre de 10 ppm.

Le second type d'échantillons était constitué par du silicium contenant 74 ppm de bore. Des essais, notamment ceux qui ont conduit à la courbe de la fig. 1, ont été effectués avec un plasma d'argon avec adjonction de 0,1% d'oxygène et 0,1% d'hydrogène. A titre d'exemple, on peut indiquer que l'élimination de 20 ppm de bore a exigé quatre passages sous plasma oxygéné, alors qu'à très faible concentration d'oxygène (0,01%), la teneur de bore éliminé sur la partie purifiée dans les mêmes conditions opératoires a été de 8 ppm seulement.

Il ressort de ces essais que l'on purifie de façon parfaitement satisfaisante un silicium métallurgique contenant 5 à 10 ppm de bore par le procédé suivant l'invention, sans introduction d'impuretés annexes ayant un effet nuisible sur les propriétés photovoltaïques.

**Revendications**

1. Procédé de purification du silicium par fusion de zone, par élimination du bore, suivant lequel on effectue la fusion d'une zone d'un lingot du silicium à purifier, en dirigeant sur cette zone un jet de plasma chaud obtenu par excitation haute fréquence, et on déplace, l'un par rapport à l'autre, le jet et le lingot pour faire circuler la zone fondue le long du lingot, caractérisé en ce que l'on constitue le plasma d'un mélange de gaz plasmogène, tel que l'argon, et d'oxygène à une teneur comprise entre 100 fois et 300 fois la teneur intiale bore du sulicium, suffisamment faible pour ne pas oxyder le silicium de façon appréciable.

2. Procédé suivant la revendication 1, caractérisé en ce que l'on ajuste la teneur en oxygène du plasma à une valeur comprise entre 0,005 et 0,1%.

3. Procédé suivant l'une quelconque des revendications précédentes, caractérisé en ce que l'on crée le plasma par procédé purement inductif, sans électrodes.

4. Procédé suivant l'une quelconque des revendications précédentes, caractérisé en ce que l'on décape à l'acide le barreau pour éliminer les composés de bore, draîné en surface après fusion.

5. Procédé suivant l'une quelconque des revendications précédentes, caractérisé en ce que l'on ajoute de l'hydrogène au gaz plasmogène et à l'oxygène.

6. Procédé suivant l'une quelconque des revendications précédentes, caractérisé en ce que l'on fait suivre le traitement par un plasma contenant de l'oxygène par un traitement par un plasma sans oxygène pour éliminer les défauts.

**Patentansprüche**

1. Verfahren zum Entfernen von Bor aus Silicium durch Zonenschmelzen, bei dem man das Zonenschmelzen eines zu reinigenden Siliciumblockes dadurch bewirkt, daß auf diese Zone ein heißer durch hochfrequente Anregung gewonnener Plasmastrahl gerichtet wird, und bei dem man den Strahl und den Block so gegeneinander verschiebt, daß die geschmolzene Zone entlang der Länge des Blockes zirkuliert, dadurch gekennzeichnet, daß man das Plasma aus einer Mischung von plasmagenem Gas, wie z. B. Argon, und Sauerstoff bildet, dessen Anteil das 100- bis 300fache des Anfangsgehalts an Bor im Silicium beträgt und gering genug ist, um das Silicium nicht merklich zu oxidieren.

2. Verfahren nach Anspruch 1, dadurch gekennzeichnet, daß man den Sauerstoffgehalt des Plasmas auf einen Wert zwischen 0,005 und 0,1% einstellt.

3. Verfahren nach einem der vorhergehenden Ansprüche, dadurch gekennzeichnet, daß man das Plasma durch ein rein induktives Verfahren, ohne Elektroden, erzeugt.

4. Verfahren nach einem der vorhergehenden Ansprüche, dadurch gekennzeichnet, daß man den Stab mit Säure beizt, um die Borverbindungen, die sich nach dem Schmelzen auf der Oberfläche abgeschieden haben, zu beseitigen.

5. Verfahren nach einem der vorhergehenden Ansprüche, dadurch gekennzeichnet, daß man dem plasmagenen Gas und dem Sauerstoff Wasserstoff zusetzt.

6. Verfahren nach einem der vorhergehenden Ansprüche, dadurch gekennzeichnet, daß man auf die Behandlung mit sauerstoffhaltigem Plasma eine Behandlung mit Plasma ohne Sauerstoff folgen läßt, um die Fehler zu beseitigen.

**Claims**

1. A process for zone melting purification of silicon, including boron limination, comprising the steps of melting a zone of a bar of silicon to be purified by directing a jet of hot plasma obtained by high frequency exitation onto said zone and moving the jet and the bar with respect to each other to cause the melted zone to travel along the bar, characterized in that the plasma is formed from a mixture of a plasma producing gas, such as argon, and oxygen, the content of oxygen being between 100 times and 300 times the initial percentage of boron in the silicium, low enough to avoid substantial oxidation of silicon.

2. Process according to claim 1, characterized in that the oxygen percentage of the plasma is adjusted to a value between 0.005% and 0.1%.

3. Process according to any one of the preceding claims, characterized in that the plasma is created by a purely inductive process whithout electrodes.

4. Process according to any one of the preceding claims, characterized in that the bar is cleaned with acid to remove any boron compounds drawn to the surface after melting.

5. Process according to any one of the preceding claims, characterized in that hydrogen is added to the plasma producing gas and to the oxygen.

6. Process according to any one of the preceding claims, characterized in that said processing with an oxygen containing plasma is followed with processing with an oxygenfree plasma for eliminating the defects.

FIG.1.

FIG. 2.

FIG.3.